(19) Europäisches Patentamt
European Patent Office
Office européen des brevets

(11) **EP 4 741 860 A1**

(12) **EUROPEAN PATENT APPLICATION**

(43) Date of publication:
**13.05.2026 Bulletin 2026/20**

(21) Application number: **25211578.7**

(22) Date of filing: **28.10.2025**

(51) International Patent Classification (IPC):
**G01R 33/00** (2006.01) **G01R 33/02** (2006.01)
**G01R 33/10** (2006.01) **G06T 5/60** (2024.01)
**G06T 5/70** (2024.01)

(52) Cooperative Patent Classification (CPC):
**G06T 5/70; G01R 33/0064; G01R 33/0094;
G01R 33/0206; G01R 33/10; G06T 5/60;
G06T 2207/30148**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **07.11.2024 IN 202421085737**

(71) Applicant: **Tata Consultancy Services Limited
Mumbai, Maharashtra 400 021 (IN)**

(72) Inventors:
• **REDDY KANCHAM, Pavan Kumar
560066 Bangalore (IN)**

• **ANAND, Prabhat Sneh
560066 Bangalore (IN)**
• **KUMAR, Achanna Anil
560066 Bangalore (IN)**
• **KHANDELWAL, Ankit
560066 Bangalore (IN)**
• **CHANDRA, Mariswamy Girish
560066 Bangalore (IN)**

(74) Representative: **Goddar, Heinz J.
Boehmert & Boehmert
Anwaltspartnerschaft mbB
Pettenkoferstrasse 22
80336 München (DE)**

(54) **METHOD AND SYSTEM FOR CURRENT DENSITY MAPS RECONSTRUCTION BY JOINTLY OPTIMIZING MAGNETIC FIELD MAPS**

(57) Embodiments herein provide a method and system for current density maps reconstruction by jointly optimizing x-direction, y-direction and z-direction magnetic field maps. Herein, the method of reconstruction of current image is leveraging state of the art iterative reconstruction techniques along with deep learning techniques. The quality of the current reconstruction depends on the signal to noise ratio (SNR) of the magnetic field observed. Since the noise model is difficult to characterize, a deep neural network is trained to learn the complex noise model from the data itself. To simulate the realistic scenarios, training data is created by introducing various kinds of noise that may appear in the system and collecting the training data pairs, i.e., pair of noisy and denoised x-direction and y- direction current density maps. The DNN is trained on this paired data to learn the noise model.

FIG. 2

EP 4 741 860 A1

**Description**

CROSS-REFERENCE TO RELATED APPLICATIONS AND PRIORITY

The present application claims priority to Indian application no. 202421085737 filed on November 7, 2024.

TECHNICAL FIELD

The disclosure herein generally relates to the field of current density maps reconstruction, and more particularly, a method and system for current density maps reconstruction by jointly optimizing x-direction, y-direction and z-direction magnetic field maps.

BACKGROUND

Quantum sensing with NV (nitrogen-vacancy) centers in diamond represents a groundbreaking advancement in precision measurement. NV centers are specific defects within the diamond lattice where a nitrogen atom replaces a carbon atom, creating a vacancy adjacent to it. These centers exhibit remarkable quantum properties, such as spin states that are highly sensitive to external magnetic and electric fields. By using the NV centers as quantum sensors, researchers can achieve unprecedented levels of accuracy in detecting magnetic fields, temperature variations, and even electric fields at the nanoscale.

Once the magnetic fields are available, it is also possible to obtain the current density maps which is of great interest to the semiconductor industry as the current can be non-destructively imaged and in turn defects in semiconductor ICs can be detected.

Existing methods either use z-direction magnetic field or use x- and y-direction fields separately and combine them later. Reconstruction using just z-field has some challenges in applying the prior as we deal with the integral of the signal. Where with x and y fields we directly deal with the signal, however treating them separately leads to artifacts. Also, the reconstruction of the current image under low Signal to Noise Ratio (SNR) conditions is challenging.

SUMMARY

Embodiments of the present disclosure present technological improvements as solutions to one or more of the above-mentioned technical problems recognized by the inventors in conventional systems. For example, in one embodiment, a method for current density maps reconstruction by jointly optimizing x-direction, y-direction and z-direction magnetic field maps is provided. The processor-implemented method includes detecting a plurality of magnetic field maps along x-direction ($B_x$), y-direction ($B_y$), and z-direction ($B_z$) using a quantum sensing technique.

Further, the processor-implemented method includes representing the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$). Furthermore, the processor-implemented method includes appending the energy function with one or more predefined additional regularization functions to generate a regularized energy function. Finally, the processor-implemented method includes jointly optimizing the regularized energy function using a variable splitting technique to obtain a plurality of denoised electric current density maps along x-direction ($J_x$), and a plurality of denoised electric current density maps along y-direction ($J_y$).

In another embodiment, a system for current density maps reconstruction by jointly optimizing x-direction, y-direction and z-direction magnetic field maps is provided. The system comprises a memory storing a plurality of instructions, one or more Input/Output (I/O) interfaces, and one or more hardware processors coupled to the memory via the one or more I/O interfaces. The one or more hardware processors are configured by the instructions to detect a plurality of magnetic field maps along x-direction ($B_x$), y-direction ($B_y$), and z-direction ($B_z$) using a quantum sensing technique.

Further, the one or more hardware processors are configured by the instructions to represent the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$). The energy function is appended with one or more predefined additional regularization functions to generate a regularized energy function. Finally, the one or more hardware processors are configured by the instructions to jointly optimize the regularized energy function using a variable splitting technique to obtain a plurality of denoised electric current density maps along x-direction ($J_x$), and a plurality of denoised electric current density maps along y-direction ($J_y$).

**EP 4 741 860 A1**

In yet another aspect, there are provided one or more non-transitory machine-readable information storage mediums comprising one or more instructions, which when executed by one or more hardware processors causes a method for a current density maps reconstruction by jointly optimizing x-direction, y-direction and z-direction magnetic field maps is provided. The processor-implemented method includes detecting a plurality of magnetic field maps along x-direction ($B_x$), y-direction ($B_y$), and z-direction ($B_z$) using a quantum sensing technique.

Further, the processor-implemented method includes representing the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$). Furthermore, the processor-implemented method includes appending the energy function with one or more predefined additional regularization functions to generate a regularized energy function. Finally, the processor-implemented method includes jointly optimizing the regularized energy function using a variable splitting technique to obtain a plurality of denoised electric current density maps along x-direction ($J_x$), and a plurality of denoised electric current density maps along y-direction ($J_y$).

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates a block diagram of a system for current density maps reconstruction by jointly optimizing x-direction, y-direction and z-direction magnetic field maps, according to some embodiments of the present disclosure.

FIG. 2 is a functional block diagram illustrating the system of FIG. 1 for current density maps reconstruction by jointly optimizing x-direction, y-direction and z-direction magnetic field maps, according to some embodiments of the present disclosure.

FIG. 3 is an exemplary flow diagram illustrating a processor-implemented method for current density maps reconstruction by jointly optimizing x-direction, y-direction and z-direction magnetic field maps, according to some embodiments of the present disclosure.

FIG. 4 is a block diagram to illustrate an iterative approach for jointly denoising, according to some embodiments of the present disclosure.

FIG. 5 is a functional block diagram to illustrate denoising, according to some embodiments of the present disclosure.

FIG. 6 is a functional block diagram to illustrate training of a Deep Neural Network (DNN) denoising model, according to some embodiments of the present disclosure.

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The magnetic fields detected through the Nitrogen Vacancy (NV) centres to obtain the current density maps is of great interest to the semiconductor industry as it could be possible to non-destructively image the current and in turn detect defects in semiconductor ICs. Reconstruction using just the magnetic field along z-direction has some challenges in applying the prior as it is to be considered with the integral of a signal. The magnetic fields long x-direction and y-direction directly deal with the signal, however treating them separately leads to artifacts. Also, the reconstruction of the current image under low Signal-to-noise ratio (SNR) conditions is challenging.

Embodiments herein provide a method and system for current density maps reconstruction by jointly optimizing x-direction, y-direction and z-direction magnetic field maps. Herein, the method of reconstruction of current image is leveraging state of the art iterative reconstruction techniques along with deep learning techniques. The quality of the current reconstruction depends on the signal to noise ratio (SNR) of the magnetic field observed. Since the noise model is difficult to characterize, a deep neural network is trained to learn the complex noise model from the data itself. To simulate the realistic scenarios, training data is created by introducing various kinds of noise that may appear in the system and collecting the training data pairs, i.e., pair of noisy and denoised x-direction and y- direction current density maps. The DNN is trained on this paired data to learn the noise model.

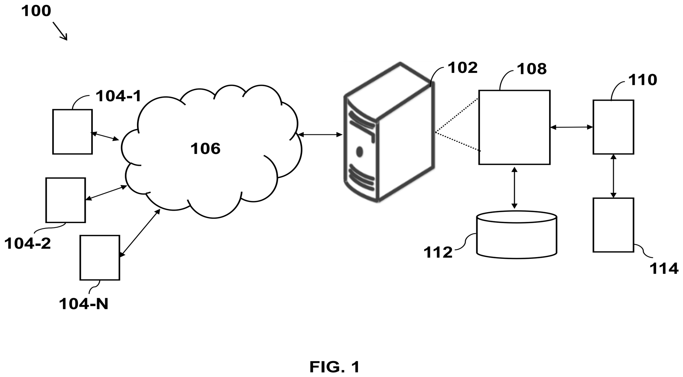

Referring now to the drawings, and more particularly to FIG. 1 through FIG. 6, where similar reference characters denote corresponding features consistently throughout the figures, there are shown preferred embodiments, and these embodiments are described in the context of the following exemplary system and/or method.

FIG. 1 illustrates a block diagram of a system 100 for current density maps reconstruction by jointly optimizing x-direction, y-direction and z-direction magnetic field maps, according to some embodiments of the present disclosure. Although the present disclosure is explained considering that the system 100 is implemented on a server, it may be understood that the system 100 may comprise one or more computing devices 102, such as a laptop computer, a desktop computer, a notebook, a workstation, a cloud-based computing environment and the like. It will be understood that the system 100 may be accessed through one or more input/output interfaces 104-1, 104-2... 104-N, referred as I/O interface 104. Examples of the I/O interface 104 may include, but are not limited to, a user interface, a portable computer, a personal digital assistant, a handheld device, a smartphone, a tablet computer, a workstation, and the like. The I/O interface 104 is communicatively coupled to the system 100 through a network 106.

In an embodiment, the network 106 may be a wireless or a wired network, or a combination thereof. In an example, the network 106 can be implemented as a computer network, as one of the different types of networks, such as virtual private network (VPN), intranet, local area network (LAN), wide area network (WAN), the internet, and such. The network 106 may either be a dedicated network or a shared network, which represents an association of the different types of networks that use a variety of protocols, for example, Hypertext Transfer Protocol (HTTP), Transmission Control Protocol/Internet Protocol (TCP/IP), and Wireless Application Protocol (WAP), to communicate with each other. Further, the network 106 may include a variety of network devices, including routers, bridges, servers, computing devices, storage devices. The network devices within the network 106 may interact with the system 100 through communication links.

The system 100 supports various connectivity options such as BLUETOOTH®, USB, ZigBee, and other cellular services. The network environment enables connection of various components of the system 100 using any communication link including Internet, WAN, MAN, and so on. In an exemplary embodiment, the system 100 is implemented to operate as a stand-alone device. In another embodiment, the system 100 may be implemented to work as a loosely coupled device to a smart computing environment. Further, the system 100 comprises at least one memory 110 with a plurality of instructions, one or more databases 112, and one or more hardware processors 108 which are communicatively coupled with the at least one memory to execute a plurality of modules 114 therein. The components and functionalities of the system 100 are described further in detail.

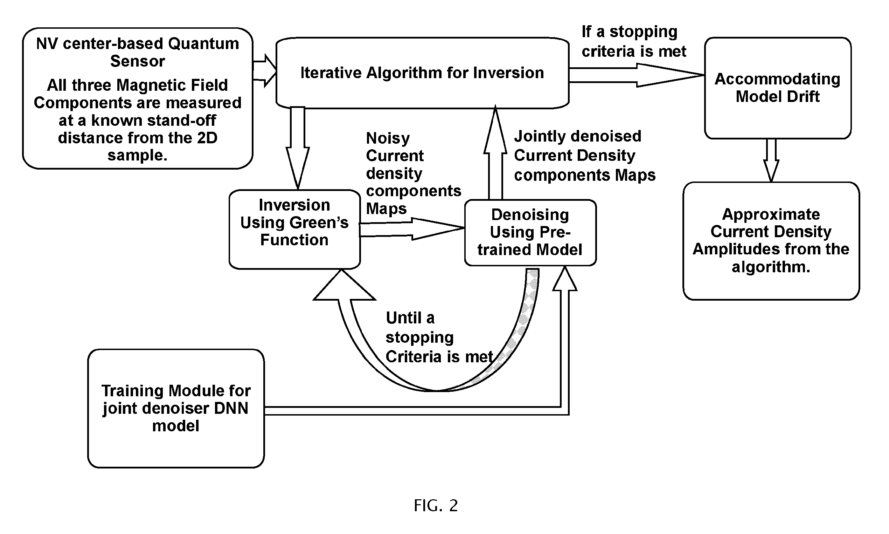

FIG. 2 is a functional block diagram 200 to illustrate the system 100 for current density maps reconstruction by jointly optimizing x-direction, y-direction and z-direction magnetic field maps, according to some embodiments of the present disclosure.

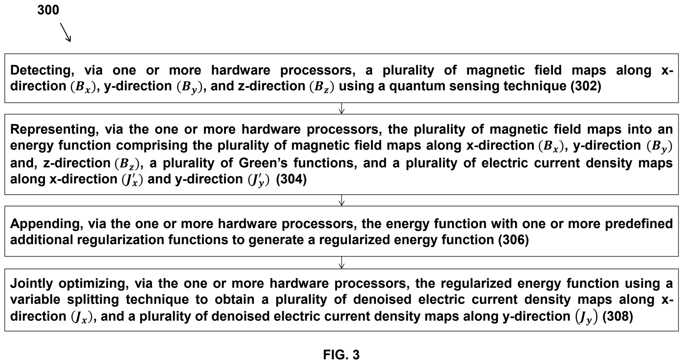

FIG. 3 is a flow diagram illustrating a processor-implemented method 300 for current density maps reconstruction by jointly optimizing x-direction, y-direction and z-direction magnetic field maps implemented by the system 100 of FIG. 1, in accordance with an embodiment of the present disclosure. Functions of the components of the system 100 are now explained through steps of flow diagram in FIG. 3, according to some embodiments of the present disclosure. In the method and system for current density maps reconstruction by jointly optimizing x-direction, y-direction and z-direction magnetic field maps.

Initially, at step 302 of the processor-implemented method 300, the one or more hardware processors 108 are configured by the programmed instructions to detect a plurality of magnetic field maps along x-direction ($B_x$), y-direction ($B_y$), and z-direction ($B_z$) using a quantum sensing technique.

At the next step 304 of the processor-implemented method 300, the one or more hardware processors 108 are configured by the programmed instructions to represent the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ( $J'_x$ ) and y-direction ( $J'_y$ ).

Herein, a variational joint optimization technique is used to solve current density maps. Given the magnetic field maps along x-direction ($B_x$), y-direction ($B_y$) and, z-direction ($B_z$), a forward model for current density maps is written as:

$$\frac{w_x}{2}||B_x - G_3 J_y||_2^2 + \frac{w_y}{2}||B_y + G_3 J_x||_2^2 + \frac{w_z}{2}||B_z - G_1 J_x + G_2 J_y||_2^2 \qquad (1)$$

wherein, different tunable weights $w_x$, $w_y$ and $w_z$ for each fidelity term. $G_1$, $G_2$ and $G_3$ are Green's function kernels corresponding to convolution by the Biot-Savart Law. $B_x$, $B_y$ and $B_z$ are the inputs to the algorithm and measured by quantum sensor at some distance above the sample.

The electric current density maps along x-direction ($J_x$) and electric current density maps along y-direction ($J_y$) may be obtained by minimizing a following cost function with additional regularization and after applying the variable splitting technique.

$$\frac{w_x}{2}||B_x - G_3 J_y||_2^2 + \frac{w_y}{2}||B_y + G_3 J_x||_2^2 + \frac{w_z}{2}||B_z - G_1 J_x + G_2 J_y||_2^2 +$$

$$\mu\left(\mathcal{R}(J_x') + \mathcal{R}(J_y')\right) + \lambda(||J_x' - J_x||)_2^2 + \lambda(||J_y' - J_y||)_2^2 \qquad (2)$$

wherein $J_x'$ and $J_y'$ are auxiliary variables introduced by the variable splitting technique. $\mu$ and $\lambda$ are the weight associated to the regularizer and proximal term respectively.

Because of the symmetric distribution of $J_x$ and $J_y$, both constants are same for both $J_x$ and $J_y$ pairs. Furthermore, to couple the denoising process, the $J_x'$ and $J_y'$ are coupled by stacking them vertically and re-write equation (2) as:

$$\frac{w_x}{2}||B_x - G_3 J_y||_2^2 + \frac{w_y}{2}||B_y + G_3 J_x||_2^2 + \frac{w_z}{2}||B_z - G_1 J_x + G_2 J_y||_2^2 + \mu\mathcal{R}\binom{J_x'}{J_y'} +$$

$$\lambda||\binom{J_x'}{J_y'} - \binom{J_x}{J_y}||_2^2 \qquad (3)$$

Equation (3) helps to jointly denoise the $J_x'$ and $J_y'$ to improve the quality as they are dependent on each other. Further, by using a half quadratic splitting (HQS) scheme to the equation (3) leads to a following iterative scheme:

$$J_x^{(k+1)} = (I\lambda + w_y \hat{G}_3^T \hat{G}_3 + w_z \hat{G}_2^T \hat{G}_2)^{-1} (w_z \hat{G}_2^T B_z + w_z \hat{G}_2^T \hat{G}_1 J_y^{(k)} + \lambda J_x'^{(k)} - w_y \hat{G}_3^T B_y)$$

$$(4)$$

$$J_y^{(k+1)} = (I\lambda + w_x \hat{G}_3^T \hat{G}_3 + w_z \hat{G}_1^T \hat{G}_1)^{-1} (w_z \hat{G}_1^T B_z + w_z \hat{G}_1^T \hat{G}_2 J_x^{(k)} + \lambda J_y'^{(k)} - w_x \hat{G}_3^T B_x)$$

$$(5)$$

$$\binom{J_x'^{(k+1)}}{J_y'^{(k+1)}} = \arg\min_{\binom{J_x'}{J_y'}} \mu\mathcal{R}\binom{J_x'}{J_y'} + \lambda \left\|\binom{J_x'}{J_y'} - \binom{J_x^{(k+1)}}{J_y^{(k+1)}}\right\|_2^2 \qquad (6)$$

wherein, $J_x$, $J_x'$ and $J_y$, $J_y'$ are vectorized. $G_1$, $G_2$ and $G_3$ are the convolution metrices corresponding to the vectorized current densities and auxiliary variables. '$I$' is an identify matrix with the same size as convolution matrices.

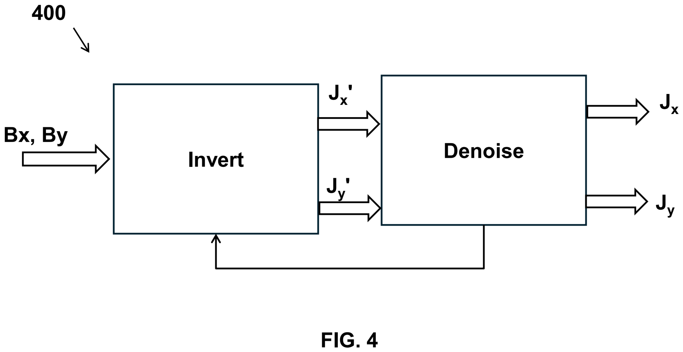

FIG. 4 is a block diagram 400 to illustrate an iterative approach for jointly denoising, according to some embodiments of the present disclosure. At each iteration, inversion and denoising is performed. The formulation is set up such that it is convenient for joint denoising of $J_x$ and $J_y$. All four variables, $J_x$, $J_x'$ and $J_y$, $J_y'$ are initialized based on an initial guess or randomly. Parameters of the technique like $\mu$, $\lambda$, $w_x$, $w_y$ and $w_z$ are kept chosen empirically and kept the same throughout the iterative optimization. $G_1$, $G_2$ and $G_3$ are Green's function constraining the information of convolution and $B_x$, $B_y$ and $B_z$ are taken as an input to the technique. Then all three steps are repeated sequentially until the stopping criteria is met. After each iteration, the new pair of $J_x'$ and $J_y'$ are calculated. The output of the immediate previous iteration is also saved. If the current estimate does not change significantly, i.e., the difference is below a certain set threshold, then the technique is assumed to have converged, and the iterative process is stopped.

At the next step 306 of the processor-implemented method 300, the one or more hardware processors 108 are configured by the programmed instructions to append the energy function with one or more additional regularization functions to generate a regularized energy function. The additional regularization function is performed by the denoiser.

Finally, at the last step 308 of the processor-implemented method 300, the one or more hardware processors 108 are configured by the programmed instructions to jointly optimize the regularized energy function using a variable splitting technique to obtain a plurality of denoised electric current density maps along x-direction ($J_x$), and a plurality of denoised electric current density maps along y-direction ($J_y$).

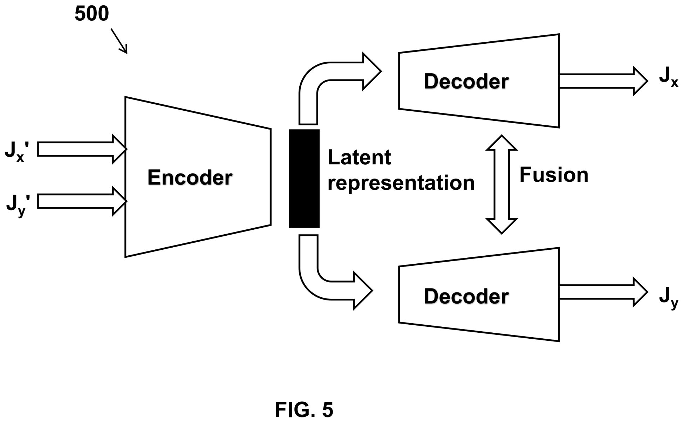

Referring to FIG. 5, a functional block diagram to illustrate denoising, according to some embodiments of the present disclosure. The encoder provides a compact latent representation of the input. At the decoder side, there are two branches to provide denoised current density maps along x-direction ($J_x$), and denoised electric current density maps along y-direction ($J_y$). Herein, fusion layers are added between the two branches for information exchange between the branches for effective denoising.

The regularized energy function is jointly optimized by iteratively performing inversion mechanism on the plurality of magnetic field maps along x-direction ($B_x$) and y-direction ($B_y$), and z-direction ($B_z$), to obtain a plurality of noisy electric current density maps along x-direction ($J'_x$), and a plurality of noisy electric current density maps along y-direction ($J'_y$). And jointly denoising the plurality of noisy electric current density maps along x-direction ($J'_x$) and the plurality of noisy electric current density maps along y-direction ($J'_y$), using a pretrained Deep Neural Network (DNN) denoising model.

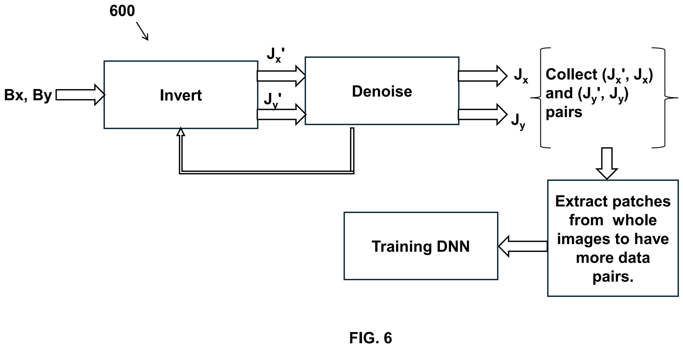

FIG. 6 is a functional block diagram 600 to illustrate training of a DNN denoising model, according to some embodiments of the present disclosure. The DNN denoising model is trained by collecting a plurality of x-direction electric current density map pairs and a plurality of y-direction electric current density map pairs and feeding the plurality of x-direction electric current density map pairs and the plurality of y-direction electric current density map pairs to the DNN denoising model to train the DNN denoising model. Herein, the plurality of x-direction electric current density map pairs and the plurality of y-direction electric current density map pairs comprising noisy electric current density maps of different noise levels and types mapped with the same denoised electric current density map.

The noise levels may include but are not limited to noise due to optical components (major contributor) like LASERs and lenses that has a near gaussian nature and noise in the CCD or any other camera are used for Photoluminescence detection. Similarly, there are errors due to shift in Stand-off and error due to misaligned NV center crystal.

Upon receiving a new noisy electric current density map along x-direction ($J'_x$) and a new noisy current density map along y-direction ($J'_y$), the trained DNN denoising model predicts the denoised electric current density map along x-direction ($J_x$), and denoised electric current density map along y-direction ($J_y$). Herein, the x-direction electric current density map pair is comprising of a noisy electric current density map along x-direction ($J'_x$) and a denoised electric current density map along x-direction ($J_x$). The y-direction electric current density map pair is comprising of a noisy electric current density map along y-direction ($J'_y$) and a denoised electric current density map along y-direction ($J_y$).

In one example, where non-destructive investigation of faults in semiconductor chips is of paramount importance. For a given semiconductor IC layout and for a known current flowing through the circuit (producing the current densities $J_x$ and $J_y$), one can predetermine the magnetic field $B_x$, $B_y$ and $B_z$ that can be expected at any given stand-off distance. When a new batch of ICs is available for testing, defects may be determined by comparing the current density maps obtained from the measured magnetic field against the expected current density maps. If the deviation is beyond a certain set limit, it would indicate a defect in the IC, and probably an error in the fabricating process.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of the present disclosure herein address unresolved problems of current density maps reconstruction by jointly optimizing x-direction, y-direction and z-direction magnetic field maps. Herein, the method of reconstruction of current image is leveraging state of the art iterative reconstruction techniques along with deep learning techniques. The quality of the current reconstruction depends on the signal to noise ratio (SNR) of the magnetic field observed. Since the noise model is difficult to characterize, a deep neural network is trained to learn the complex noise model from the data itself. To simulate the realistic scenarios, training data is created by introducing various kinds of noise that may appear in the system and collecting the training data pairs, i.e., pair of noisy and denoised x-direction and y-direction current density maps. The DNN is trained on this paired data to learn the noise model.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor-implemented method (300) for current density maps reconstruction by jointly optimizing x-direction, y-direction and z-direction magnetic field maps comprising:

   detecting (302), via one or more hardware processors, a plurality of magnetic field maps along x-direction ($B_x$), y-direction ($B_y$), and z-direction ($B_z$) using a quantum sensing technique;
   representing (304), via the one or more hardware processors, the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$);
   appending (306), via the one or more hardware processors, the energy function with one or more predefined additional regularization functions to generate a regularized energy function; and
   jointly optimizing (308), via the one or more hardware processors, the regularized energy function using a variable splitting technique to obtain a plurality of denoised electric current density maps along x-direction ($J_x$), and a plurality of denoised electric current density maps along y-direction ($J_y$).

2. The processor-implemented method (300) as claimed in claim 1, wherein jointly optimizing the regularized energy function using a variable splitting technique by:

   iteratively performing inversion mechanism on the plurality of magnetic field maps along x-direction ($B_x$) and y-direction ($B_y$), and z-direction ($B_z$), to obtain a plurality of noisy electric current density maps along x-direction ($J'_x$), and a plurality of noisy electric current density maps along y-direction ($J'_y$); and

jointly denoising the plurality of noisy electric current density maps along x-direction ($J'_x$) and the plurality of noisy electric current density maps along y-direction ($J'_y$), using a pretrained Deep Neural Network (DNN) denoising model.

3. The processor-implemented method (300) as claimed in claim 2, wherein the DNN denoising model is trained by:

collecting a plurality of x-direction electric current density map pairs and a plurality of y-direction electric current density map pairs; and
feeding the plurality of x-direction electric current density map pairs and the plurality of y-direction electric current density map pairs to the DNN denoising model to train the DNN denoising model.

4. The processor-implemented method (300) as claimed in claim 1, wherein the trained DNN denoising model upon receiving a new noisy electric current density map along x-direction ($J'_x$) and a new noisy current density map along y-direction ($J'_y$), predicts the denoised electric current density map along x-direction ($J_x$), and denoised electric current density map along y-direction ($J_y$).

5. The processor-implemented method (300) as claimed in claim 1, wherein a x-direction electric current density map pair is comprising of a noisy electric current density map along x-direction ($J'_x$) and a denoised electric current density map along x-direction ($J_x$).

6. The processor-implemented method (300) as claimed in claim 1, wherein a y-direction electric current density map pair is comprising of a noisy electric current density map along y-direction ($J'_y$) and a denoised electric current density map along y-direction ($J_y$).

7. A system (100) current reconstruction by joint optimization x-direction and y-direction magnetic field comprising:

a memory (110) storing instructions;
one or more Input/Output (I/O) interfaces (104); and
one or more hardware processors (108) coupled to the memory (110) via the one or more I/O interfaces (104), wherein the one or more hardware processors (108) are configured by the instructions to:

detect a plurality of magnetic field maps along x-direction ($B_x$), y-direction ($B_y$), and z-direction ($B_z$) using a quantum sensing technique;
represent the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$);
append the energy function with one or more additional regularization functions to generate a regularized energy function; and
jointly optimize the regularized energy function using a variable splitting technique to obtain a plurality of denoised electric current density maps along x-direction ($J_x$), and a plurality of denoised electric current density maps along y-direction ($J_y$).

8. The system (100) as claimed in claim 7, wherein the one or more hardware processors are configured to jointly optimize the regularized energy function using the variable splitting technique by:

iteratively performing inversion mechanism on the plurality of magnetic field maps along x-direction ($B_x$) and y-direction ($B_y$), and z-direction ($B_z$), to obtain a plurality of noisy electric current density maps along x-direction ($J'_x$), and a plurality of noisy electric current density maps along y-direction ($J'_y$); and

jointly denoising the plurality of noisy electric current density maps along x-direction ($J'_x$) and the plurality of noisy electric current density maps along y-direction ($J'_y$), using a pretrained Deep Neural Network (DNN) denoising model.

9. The system (100) as claimed in claim 8, wherein the DNN denoising model is trained by:

   collecting a plurality of x-direction electric current density map pairs and a plurality of y-direction electric current density map pairs; and

   feeding the plurality of x-direction electric current density map pairs and the plurality of y-direction electric current density map pairs to the DNN denoising model to train the DNN denoising model.

10. The system (100) as claimed in claim 7, wherein the trained DNN noise model upon receiving a new noisy electric current density map along x-direction ($J'_x$) and a new noisy current density map along y-direction ($J'_y$), predicts the denoised electric current density map along x-direction ($J_x$), and denoised electric current density map along y-direction ($J_y$).

11. The system (100) as claimed in claim 7, wherein a x-direction electric current density map pair of the plurality of x-direction electric current density map pairs is composed of a noisy electric current density map along x-direction ($J'_x$) and a denoised electric current density map along x-direction ($J_x$).

12. The system (100) as claimed in claim 7, wherein a y-direction electric current density map pair of the plurality of y-direction electric current density map pairs is composed of the plurality of noisy electric current density map pair along y-direction ($J_y$) and a denoised electric current density map pair along y-direction ($J_y$).

13. One or more non-transitory machine-readable information storage mediums comprising one or more instructions which when executed by one or more hardware processors cause:

   detecting a plurality of magnetic field maps along x-direction ($B_x$), y-direction ($B_y$), and z-direction ($B_z$) using a quantum sensing technique;

   representing the plurality of magnetic field maps into an energy function comprising the plurality of magnetic field maps along x-direction ($B_x$), y-direction ($B_y$) and, z-direction ($B_z$), a plurality of Green's functions, and a plurality of electric current density maps along x-direction ($J'_x$) and y-direction ($J'_y$);

   appending the energy function with one or more additional regularization functions to generate a regularized energy function; and

   jointly optimizing the regularized energy function using a variable splitting technique to obtain a plurality of denoised electric current density maps along x-direction ($J_x$), and a plurality of denoised electric current density maps along y-direction ($J_y$).

14. The one or more non-transitory machine-readable information storage mediums as claimed in claim 13, wherein jointly optimizing the regularized energy function using a variable splitting technique by:

   iteratively performing inversion mechanism on the plurality of magnetic field maps along x-direction ($B_x$) and y-direction ($B_y$), and z-direction ($B_z$), to obtain a plurality of noisy electric current density maps along x-direction ($J'_x$), and a plurality of noisy electric current density maps along y-direction ($J'_y$); and

   jointly denoising the plurality of noisy electric current density maps along x-direction ($J'_x$) and the plurality of noisy electric current density maps along y-direction ($J'_y$), using a pretrained Deep Neural Network (DNN) denoising model.

15. The one or more non-transitory machine-readable information storage mediums as claimed in claim 14, wherein the DNN denoising model is trained by:

   collecting a plurality of x-direction electric current density map pairs and a plurality of y-direction electric current density map pairs; and

   feeding the plurality of x-direction electric current density map pairs and the plurality of y-direction electric current density map pairs to the DNN denoising model to train the DNN denoising model.

FIG. 1

NV center-based Quantum Sensor

All three Magnetic Field Components are measured at a known stand-off distance from the 2D sample.

Iterative Algorithm for Inversion

If a stopping criteria is met

Accommodating Model Drift

Approximate Current Density Amplitudes from the algorithm.

Jointly denoised Current Density components Maps

Noisy Current density components Maps

Denoising Using Pre-trained Model

Inversion Using Green's Function

Until a stopping Criteria is met

Training Module for joint denoiser DNN model

FIG. 2

**300**

Detecting, via one or more hardware processors, a plurality of magnetic field maps along x-direction $(B_x)$, y-direction $(B_y)$, and z-direction $(B_z)$ using a quantum sensing technique (302)

Representing, via the one or more hardware processors, the plurality of magnetic field maps into an energy function comprising the plurality of magnetic field maps along x-direction $(B_x)$, y-direction $(B_y)$ and, z-direction $(B_z)$, a plurality of Green's functions, and a plurality of electric current density maps along x-direction $(J'_x)$ and y-direction $(J'_y)$ (304)

Appending, via the one or more hardware processors, the energy function with one or more predefined additional regularization functions to generate a regularized energy function (306)

Jointly optimizing, via the one or more hardware processors, the regularized energy function using a variable splitting technique to obtain a plurality of denoised electric current density maps along x-direction $(J_x)$, and a plurality of denoised electric current density maps along y-direction $(J_y)$ (308)

**FIG. 3**

**FIG. 4**

**FIG. 5**

**600**

Bx, By → **Invert** → $J_x'$ / $J_y'$ → **Denoise** → $J_x$ / $J_y$ → Collect ($J_x'$, $J_x$) and ($J_y'$, $J_y$) pairs → **Extract patches from whole images to have more data pairs.** → **Training DNN**

**FIG. 6**

Europäisches
Patentamt

European
Patent Office

Office européen
des brevets

# EUROPEAN SEARCH REPORT

**Application Number**

EP 25 21 1578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | NIKO R. REED ET AL: "Machine Learning for Improved Current Density Reconstruction from 2D Vector Magnetic Images", ARXIV.ORG CORNELL UNIVERSITY LIBRARY, 201 OLIN LIBRARY CORNELL UNIVERSITY ITHACA, NY 14853, 4 August 2024 (2024-08-04), XP091839308, * the whole document * * page 2; figure 1 * * page 8 - page 9 * ----- | 1-15 | INV. G01R33/00 G01R33/02 G01R33/10 G06T5/60 G06T5/70 |
| Y | CHANG K. ET AL: "Nanoscale Imaging of Current Density with a Single-Spin Magnetometer", NANO LETTERS, vol. 17, no. 4, 24 March 2017 (2017-03-24) , pages 2367-2373, XP093381007, United States ISSN: 1530-6984, DOI: 10.1021/acs.nanolett.6b05304 * the whole document * * page 4 * ----- | 1-15 | |
| A | A. E. E. DUBOIS ET AL: "Untrained physically informed neural network for image reconstruction of magnetic field sources", ARXIV.ORG CORNELL UNIVERSITY LIBRARY, 201 OLIN LIBRARY CORNELL UNIVERSITY ITHACA, NY 14853, 27 July 2022 (2022-07-27), XP091281953, * the whole document * ----- | 1-15 | TECHNICAL FIELDS SEARCHED (IPC) G01R G06T |
| A | CN 116 930 594 A (BEIJING SMARTCHIP MICROELECTRONICS TECH CO LTD ET AL.) 24 October 2023 (2023-10-24) * the whole document * ----- | 1-15 | |

-/--

The present search report has been drawn up for all claims

| Place of search | Date of completion of the search | Examiner |
|---|---|---|
| Munich | 26 March 2026 | Warneck, Nicolas |

EPO FORM 1503 03.82 (P04C01)

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

Europäisches
Patentamt

European
Patent Office

Office européen
des brevets

**EUROPEAN SEARCH REPORT**

Application Number

EP 25 21 1578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | COLIN B. CLEMENT ET AL: "Reconstruction of current densities from magnetic images by Bayesian Inference", ARXIV.ORG CORNELL UNIVERSITY LIBRARY, 201 OLIN LIBRARY CORNELL UNIVERSITY ITHACA, NY 14853, 28 October 2019 (2019-10-28), XP081522199, * the whole document * | 1-15 | |

-----

TECHNICAL FIELDS
SEARCHED      (IPC)

The present search report has been drawn up for all claims

| Place of search | Date of completion of the search | Examiner |
|---|---|---|
| Munich | 26 March 2026 | Warneck, Nicolas |

EPO FORM 1503 03.82 (P04C01)

# EP 4 741 860 A1

## ANNEX TO THE EUROPEAN SEARCH REPORT
## ON EUROPEAN PATENT APPLICATION NO.

EP 25 21 1578

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2026

| Patent document cited in search report | Publication date | Patent family member(s) | Publication date |
|---|---|---|---|
| CN 116930594 A | 24-10-2023 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202421085737